# EUROPEAN PATENT APPLICATION

(11) **EP 4 773 179 A1**
(43) Date of publication of application: **08.07.2026**
(21) Application number: 24859296.6
(22) Date of filing: 30.07.2024
(51) Int. Cl.: H01L 21/683, B23K 26/38

(54) **SEMICONDUCTOR MANUFACTURING DEVICE AND FILM-CUTTING MECHANISM**

(30) Priority: 31.08.2023 JP 2023141613
(71) Applicant: Teikoku Taping System Co., Ltd., Tokai-shi, Aichi 477-0032 (JP)
(72) Inventor: KATSUSHIMA, Yoshinori, Tokai-shi, Aichi 477-0032 (JP)
(74) Representative: Epping - Hermann - Fischer
(86) International application number: PCT/JP2024/027154
(87) International publication number: WO 2025/047254

(57) **Abstract**

A film attaching device (1) includes: a table (2) configured to support a semiconductor wafer W; and a cutting unit (19) configured to cut, with a laser (LS), a photoresist film (6) attached to the semiconductor wafer (W) placed on the table (2). The cutting unit (19) includes: a laser source (61); and a beam expander (63) configured to expand or reduce the beam diameter of the laser (LS) emitted from the laser source (61).

## Description

### TECHNICAL FIELD

The present disclosure relates to a semiconductor manufacturing device and a film-cutting mechanism.

### BACKGROUND ART

A device is known in the related art, which includes: a table configured to support a silicon wafer (semiconductor wafer); and a means for cutting a film along an outer periphery of the semiconductor wafer, the film being attached to the semiconductor wafer placed on the table (see Patent Document 1).

### CITATION LIST

### PATENT LITERATURE

Patent Document 1: Japanese Patent No. 4728534

### SUMMARY OF THE INVENTION

### PROBLEM TO BE SOLVED BY THE INVENTION

The above-described device is configured to cut the film by irradiating the film with a laser. Thus, the quality of the cut edge of the film is affected by the laser spot diameter. If the spot diameter is not appropriate, the quality of the cut edge of the film may be degraded.

Therefore, it is desirable to provide a semiconductor manufacturing device capable of enhancing the quality of the cut edge of the film.

### MEANS FOR SOLVING THE PROBLEM

A semiconductor manufacturing device according to an embodiment of the present invention includes: a table configured to support a semiconductor wafer; and a film-cutting mechanism configured to cut a film with a laser, the film being attached to the semiconductor wafer placed on the table, in which the film-cutting mechanism includes: a laser source; and a beam expander configured to expand or reduce a beam diameter of the laser emitted from the laser source.

### ADVANTAGEOUS EFFECTS OF THE INVENTION

The above-described semiconductor manufacturing device is capable of enhancing the quality of the cut edge of the film.

### BRIEF DESCRIPTION OF THE DRAWINGS

[FIG. 1] FIG. 1 is a side view of a film attaching device according to an embodiment of the present disclosure.
[FIG. 2] FIG. 2 is a diagram illustrating functions of a controller mounted on the film attaching device.
[FIG. 3] FIG. 3 is a diagram illustrating a pressing pattern.
[FIG. 4] FIG. 4 is a side view of the film attaching device when a moving unit is moved toward a left end.
[FIG. 5] FIG. 5 is a side view of the film attaching device when the moving unit is moved toward a right end.
[FIG. 6] FIG. 6 is a view showing an example of a film to be trimmed by a cutting unit.
[FIG. 7] FIG. 7 is a view showing a configuration example of a hollow structure.
[FIG. 8] FIG. 8 is a view showing the configuration example of the hollow structure.
[FIG. 9] FIG. 9 is a view showing a configuration example of a raising and lowering support mechanism.
[FIG. 10] FIG. 10 is a right side view of an outer peripheral support member and the raising and lowering support mechanism.
[FIG. 11] FIG. 11 is a bottom view of the outer peripheral support member and the raising and lowering support mechanism.
[FIG. 12] FIG. 12 is a top view of a semiconductor wafer placed on a table and the outer peripheral support member.
[FIG. 13] FIG. 13 is a perspective view of the cutting unit.
[FIG. 14] FIG. 14 is a top view, a rear view, and a right side view of the cutting unit.
[FIG. 15] FIG. 15 is a view showing a configuration example of a laser unit.
[FIG. 16] FIG. 16 is a cross-sectional view of the laser unit.
[FIG. 17] FIG. 17 is a view showing a configuration example of an upper discharge system.
[FIG. 18] FIG. 18 is views showing a configuration example of a lower discharge system.
[FIG. 19] FIG. 19 is a cross-sectional view of the discharge system.

### DESCRIPTION OF THE EMBODIMENTS

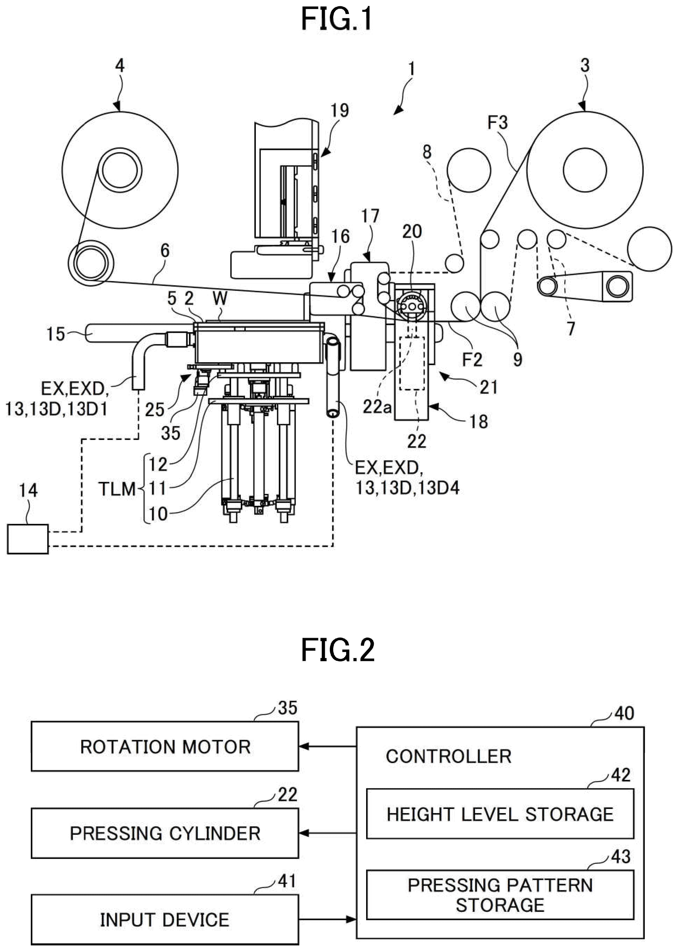

First, a film attaching device 1, which is an example of a semiconductor manufacturing device according to an embodiment of the present disclosure, will be described with reference to FIG. 1. FIG. 1 is a schematic view of the film attaching device 1.

The film attaching device 1 is used to attach a film, such as a photoresist film 6, to a semiconductor wafer W, and includes a table 2 that is circular in plan view and configured to support a semiconductor wafer W that is circular in plan view. A film supply unit 3 and a winding unit 4 are arranged at a predetermined distance from each other at positions obliquely above the table 2. A three-layer film F3 is supplied from the film supply unit 3. In the illustrated example, the three-layer film F3 is formed by laminating a carrier film 7 on one surface of the photoresist film 6 having heat-sensitive adhesiveness and a reinforcing film 8 on the other surface of the photoresist film 6. The carrier film 7 is detached from the three-layer film F3 by a pinch roller 9 to form a two-layer film F2. Then, the two-layer film F2 is pressed onto and attached to the surface of the semiconductor wafer W. Thereafter, the reinforcing film 8 is detached from the two-layer film F2 by horizontal movement of a moving unit described later.

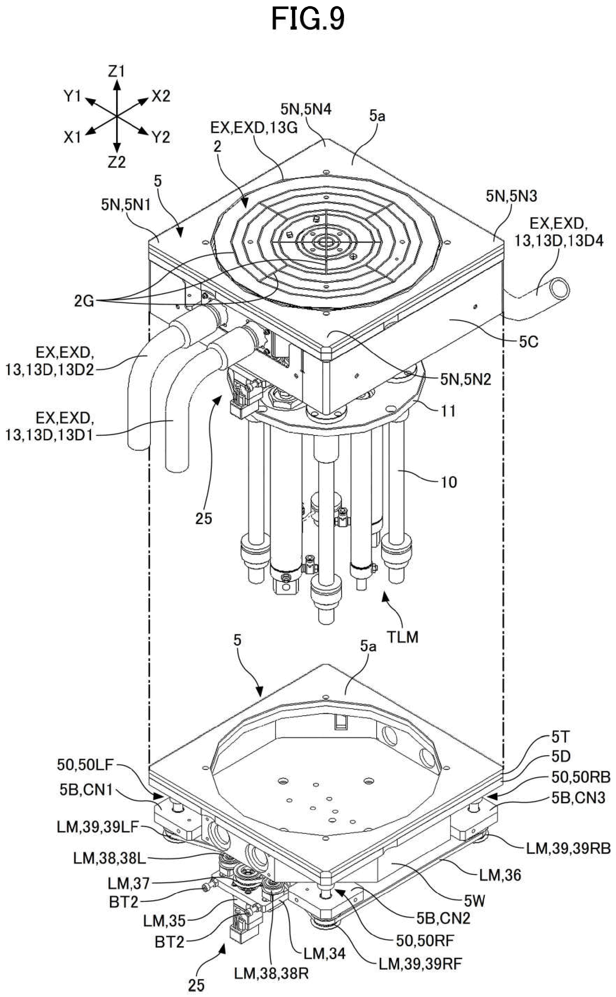

The table 2 is configured to be raised and lowered by a table raising and lowering mechanism TLM including slide rods 10, a base plate 11, and a support 12. Specifically, the table 2 is fixed, via the base plate 11 and the support 12, to upper ends of four slide rods 10 that are supported by a frame (not shown) so as to be vertically movable. The slide rods 10 are driven upward and downward by a driving force of a drive source (not shown), such as an air cylinder, to raise and lower the table 2. The table 2 has a portion of a suction passage formed therein, one end of the suction passage being open to a placement surface (a wafer-supporting surface) of the table 2 and the other end being connected to a suction source (not shown), such as a pump. In the illustrated example, the suction passage has grooves 2G (see FIG. 9) formed in the placement surface (the upper surface) of the table 2, and a plurality of through-holes formed in the grooves 2G and extending through the table 2 in a vertical direction. Accordingly, the semiconductor wafer W is held on the table 2 by a suction force generated by the suction source.

As shown in FIG. 1, a slide shaft 15 extending in a horizontal direction (a direction perpendicular to a rotation axis of the pinch roller 9) is arranged on one side of the table 2 in a direction parallel to the rotation axis of the pinch roller 9. The moving unit including a first moving unit 16, a second moving unit 17, and a third moving unit 18 is supported on the slide shaft 15 so as to be slidable. The moving unit is configured to be horizontally moved by a driving force of a drive source (not shown) such as an air cylinder. A cutting unit 19 serving as a film-cutting mechanism for trimming the photoresist film 6 attached to the semiconductor wafer W with a laser is provided above the table 2 so as to be movable horizontally. The cutting unit 19 may include a blade for cutting the film instead of the device that emits a laser for cutting the film.

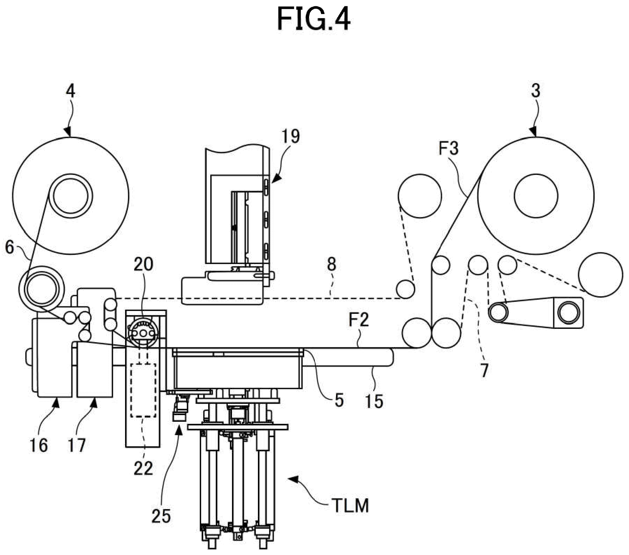

The third moving unit 18 has a pressing roller 20 for pressing the photoresist film 6 onto the surface of the semiconductor wafer W on the table 2. The pressing roller 20 is an example of a pressing member, and at least a roller surface of the pressing roller 20 is formed of an elastic material such as rubber. The film attaching device 1 can align the two-layer film F2 with the surface of the semiconductor wafer W on the table 2 by moving the moving unit (see FIG. 1) located on one end side (right end side) of the slide shaft 15 toward the other end side (left end side) of the slide shaft 15 as shown in FIG. 4. The film attaching device 1 can attach the two-layer film F2 to the surface of the semiconductor wafer W by pressing the two-layer film F2 with the pressing roller 20.

The pressing roller 20 may be configured such that a pressing force thereof is adjusted by a pressing-force adjustment mechanism 21 depending on a pressing area of the semiconductor wafer W (i.e., a contact area between the pressing roller 20 and the semiconductor wafer W). In the illustrated example, the pressing-force adjustment mechanism 21 includes a pressing cylinder 22 having a piston rod 22a. A tip of the piston rod 22a is connected to a support member (not shown) configured to support the pressing roller 20 so as to be rotatable. The pressing cylinder 22 is an example of a pressing drive source and is configured to finely adjust the protruding and retracting operation of the piston rod 22a by supplying a fluid in an amount corresponding to the pressing area of the semiconductor wafer W from a fluid supply source such as a pump.

An outer peripheral support member 5 that is rectangular and annular is provided along the outer periphery of the table 2. The outer peripheral support member 5 is also referred to as a bumper member, and has an upper surface 5a that functions as a contact surface with which the pressing roller 20 comes into contact when pressing the photoresist film 6. The outer peripheral support member 5 is supported by a raising and lowering support mechanism 25 including a rotation motor 35 so as to be capable of being raised and lowered, and is configured such that the heights of four corners of the outer peripheral support member 5 are independently adjusted. In the illustrated example, the outer peripheral support member 5 is also referred to as a digital bumper because a height level of the outer peripheral support member 5 is adjusted by computer control. A portion of an exhaust passage 13 is formed between the table 2 and the outer peripheral support member 5. One end of the exhaust passage 13 is open to the placement surface, and the other end is connected to an exhaust device 14 such as an exhaust fan or an exhaust pump. In the illustrated example, the exhaust passage 13 discharges smoke and the like generated when the film is cut by the cutting unit 19 using a laser, and includes a gap 13G (see FIG. 9), which is annular, between the table 2 and the outer peripheral support member 5, and pipes 13D (see FIG. 9) connected to a side surface of the outer peripheral support member 5. That is, in the illustrated example, the exhaust device 14 and the exhaust passage 13 (the pipes 13D and the gap 13G) form a lower discharge system EXD (air knife), which is a part of a discharge system EX configured to remove foreign matter and unwanted matter generated when the film is cut by the cutting unit 19. The unwanted matter generated when the film is cut by the cutting unit 19 includes smoke generated by heating the film with the laser. With this configuration, air flowing through the exhaust passage 13 can rapidly cool a cut surface of the film resulting from cutting by the cutting unit 19 and achieve a clean cut surface of the film without burrs or the like.

Next, functions of the film attaching device 1 will be described with reference to FIG. 2. FIG. 2 is a block diagram illustrating the functions of a controller 40 mounted on the film attaching device 1. Specifically, the film attaching device 1 includes the controller 40 configured to control the functions related to the attachment of the film. In the illustrated example, the controller 40 is a microcomputer including a central processing unit (CPU), a memory, and the like. The rotation motor 35, the pressing cylinder 22, and an input device 41 are connected to the controller 40. The input device 41 is, for example, a keyboard, a mouse, or a touch-operated device. The controller 40 includes a height level storage 42 configured to store a plurality of height levels of the outer peripheral support member 5 predetermined in accordance with the shape, size, or the like of the semiconductor wafer W, and a pressing pattern storage 43 configured to store a plurality of pressing patterns predetermined in accordance with the shape, size, or the like of the semiconductor wafer W.

In the illustrated example, the controller 40 first determines whether or not a height level switching command is input from the input device 41. When a height level switching command is input from the input device 41, the controller 40 selects a specific height level corresponding to the switching command from among the plurality of height levels stored in the height level storage 42. Thereafter, the controller 40 drives the rotation motor 35 so that the height reaches the selected height level.

The controller 40 also determines whether or not a pressing pattern switching command is input from the input device 41. When a pressing pattern switching command is input from the input device 41, the controller 40 selects a specific pressing pattern corresponding to the switching command from among the plurality of pressing patterns stored in the pressing pattern storage 43. Thereafter, the controller 40 drives the pressing cylinder 22 to apply the selected pressing pattern.

As described above, in the film attaching device 1, when a height level switching command corresponding to the shape of the semiconductor wafer W to be used is input to the controller 40, the controller 40 selects a specific height level corresponding to the switching command, and the rotation motor 35, which is a drive source for the raising and lowering support mechanism 25, is driven. As a result, the outer peripheral support member 5 is raised and lowered, and the outer peripheral support member 5 is positioned at the specific height level.

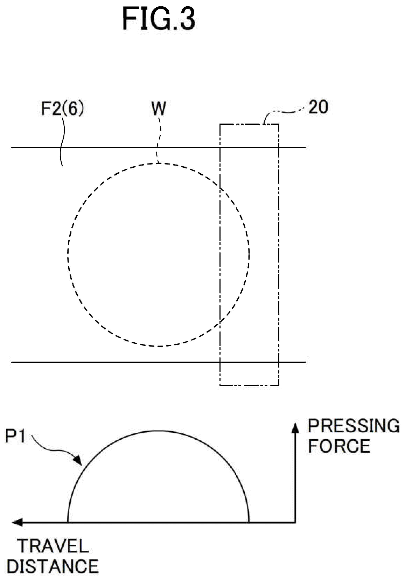

Moreover, in the film attaching device 1, when a pressing pattern switching command corresponding to the shape of the semiconductor wafer W to be used is input to the controller 40, the controller 40 selects a specific pressing pattern corresponding to the switching command. In the illustrated example, as shown in FIG. 3, a pressing pattern P1 corresponding to the semiconductor wafer W that is circular in plan view is selected.

Next, a film attaching process will be described. First, as shown in FIG. 4, the film attaching device 1 causes the moving unit (the first moving unit 16, the second moving unit 17, and the third moving unit 18) that is located on one end (right end) of the slide shaft 15 to simultaneously travel and move toward the other end (left end) of the slide shaft 15. Then, the two-layer film F2 supplied from the film supply unit 3 is aligned with the surface of the semiconductor wafer W on the table 2, and the two-layer film F2 is pressed by the pressing roller 20 of the third moving unit 18 with the pressing pattern P1 (see FIG. 3) and attached to the surface of the semiconductor wafer W. When the two-layer film F2 is pressed, the pressing roller 20 rolls, in a state of being in contact with the upper surface 5a, on the upper surface 5a of the outer peripheral support member 5 whose height level is adjusted. Note that the upper surface 5a of the outer peripheral support member 5 may be coated with Teflon (trademark) or Topical (trademark) so that the attached film is easily detached.

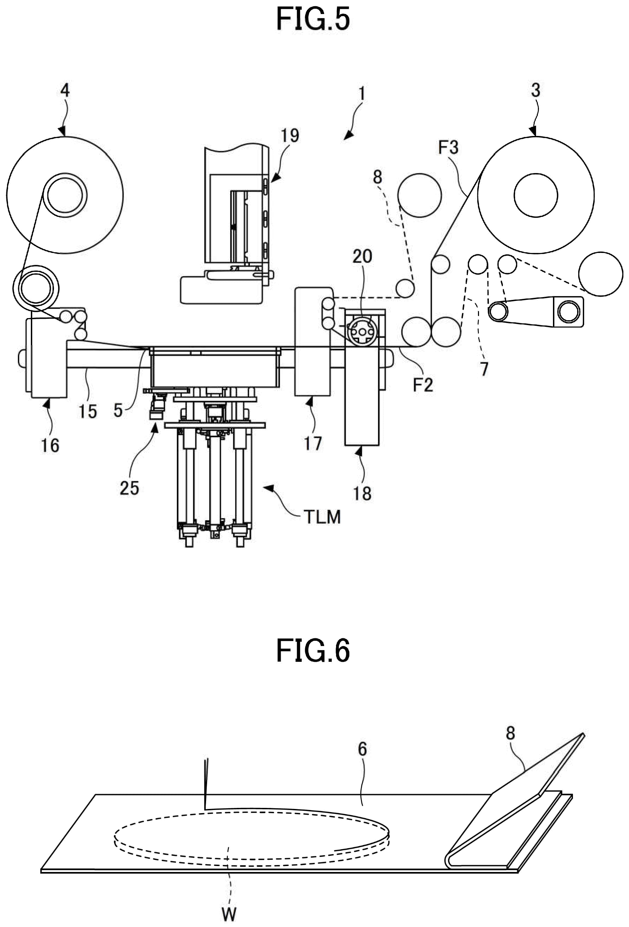

Next, as shown in FIG. 5, the film attaching device 1 moves back the second moving unit 17 and the third moving unit 18 to the original positions, thereby detaching the reinforcing film 8 from the two-layer film F2 on the semiconductor wafer W. As a result, only the photoresist film 6 remains on the surface of the semiconductor wafer W. Thereafter, the film attaching device 1 moves the cutting unit 19 horizontally along the outer peripheral edge of the semiconductor wafer W and irradiates the photoresist film 6 with a laser to trim (see FIG. 6). The remaining film, which is a portion of the photoresist film 6 other than a portion to be attached to the surface of the semiconductor wafer W, is detached by the first moving unit 16 functioning as a removing head and is wound onto the winding unit 4. As a result, the film attaching device 1 can obtain the semiconductor wafer W to which the photoresist film 6 is attached.

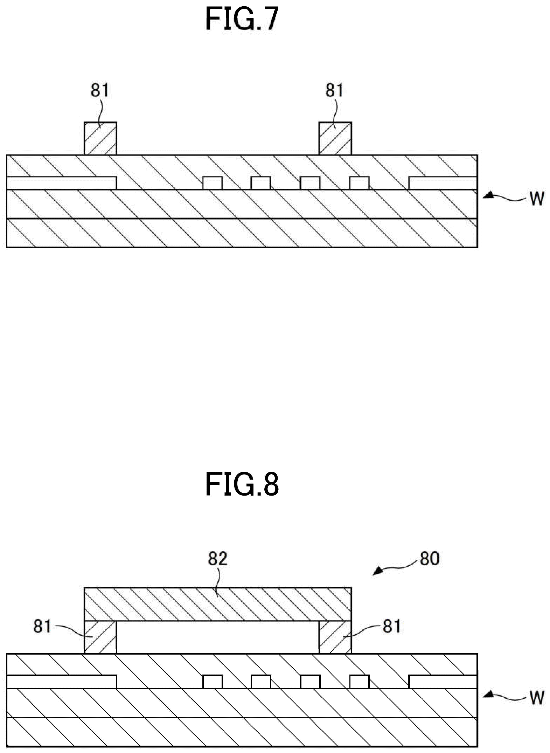

In the illustrated example, the photoresist film 6 attached to the surface of the semiconductor wafer W is then subjected to exposure processing, removal processing, and the like, and a pre-cured wall 81 is formed on the semiconductor wafer W as shown in FIG. 7. Next, a height level switching command corresponding to the semiconductor wafer W having the wall 81 is input to the controller 40, and the outer peripheral support member 5 is adjusted to the specific height level. A pressing pattern switching command corresponding to the semiconductor wafer W having the wall 81 is also input to the controller 40, and a specific pressing pattern is selected. Subsequently, the film attaching process as described above is performed again on the semiconductor wafer W having the wall 81, and the semiconductor wafer W having an additional photoresist film 6 attached on the wall 81 is obtained. Thereafter, the photoresist film 6 attached on the wall 81 is subjected to exposure processing, removal processing, and the like, and a hollow structure 80 including the wall 81 and a top portion 82 is formed on the semiconductor wafer W as shown in FIG. 8.

Note that, in the illustrated example, the height levels and the pressing patterns are different between the first film attaching processing and the second film attaching processing, but may be the same or only the height levels or the pressing patterns may be different.

The film attaching device 1 is configured to bring the pressing roller 20 into contact with the upper surface 5a of the outer peripheral support member 5 whose height level is adjusted, to press the photoresist film 6. Thus, the film attaching device 1 can minimize excessive pressing of the photoresist film 6 by the pressing roller 20 and attach the photoresist film 6 formed of a thin and soft material in a multilayer manner with minimum mechanical stress to the lower layers. In particular, when attaching the photoresist film 6 to be the wall 81 of the hollow structure 80, the film attaching device 1 can suitably absorb unevenness (surface pattern) on the surface of the semiconductor wafer W to minimize the mechanical stress on the semiconductor wafer W. Moreover, when attaching the photoresist film 6 to be the top portion 82 of the hollow structure 80, the film attaching device 1 can suitably absorb unevenness (surface pattern) on the surface of the pre-cured wall 81 to minimize the mechanical stress on the semiconductor wafer W and the wall 81.

The film attaching device 1 is configured to position the outer peripheral support member 5 at the specific height level by raising and lowering the outer peripheral support member 5 with the raising and lowering support mechanism 25 including the rotation motor 35. Therefore, the film attaching device 1 can stably attach a film to semiconductor wafers W of various shapes. As a result, the film attaching device 1 can form the hollow structure 80 having an ultrathin film thickness (e.g., about 50 µm) with excellent thickness accuracy on the semiconductor wafer W at a high yield. In particular, the film attaching device 1 can form the hollow structure 80 in a good condition on substantially the entire surface of the semiconductor wafer W. Moreover, the film attaching device 1 can form the hollow structure 80 having a larger film thickness (e.g., about 100 µm) by performing multilayer attaching of three or more photoresist films 6.

The film attaching device 1 is configured such that a pressing force of the pressing roller 20 can be adjusted by the pressing-force adjustment mechanism 21 including the pressing cylinder 22 and the like depending on a pressing area of the semiconductor wafer W. Therefore, the film attaching device 1 can stably attach a film to semiconductor wafers W of a wider variety of shapes.

The film attaching device 1 is also configured such that the height level storage 42 and the pressing pattern storage 43 are provided in the controller 40 to select a height level and a pressing pattern corresponding to the shape and the like of the semiconductor wafer W to be used, based on input information input to the controller 40. Therefore, the film attaching device 1 can stably attach a film to semiconductor wafers W of a wider variety of shapes.

Next, a configuration example of the raising and lowering support mechanism 25 configured to raise and lower the outer peripheral support member 5 will be described with reference to FIGS. 9 to 11. FIG. 9 is a view showing the configuration example of the raising and lowering support mechanism 25. Specifically, the upper part of FIG. 9 is a perspective view of the table 2, the outer peripheral support member 5, the pipes 13D, the raising and lowering support mechanism 25, and the table raising and lowering mechanism TLM. The lower part of FIG. 9 is a perspective view of the outer peripheral support member 5 and the raising and lowering support mechanism 25, corresponding to a view in which the table 2, the pipes 13D, and the table raising and lowering mechanism TLM are removed from the top part of FIG. 9. In the lower part of FIG. 9, for clarity, a side cover 5C, which is one of the components of the outer peripheral support member 5, is not shown.

In FIG. 9, X1 represents one direction of the X-axis in the three-dimensional Cartesian coordinate system, and X2 represents the other direction of the X-axis. Y1 represents one direction of the Y-axis in the three-dimensional Cartesian coordinate system, and Y2 represents the other direction of the Y-axis. Similarly, Z1 represents one direction of the Z-axis in the three-dimensional Cartesian coordinate system, and Z2 represents the other direction of the Z-axis. In FIG. 9, an X1 side of the outer peripheral support member 5 corresponds to a front side of the outer peripheral support member 5, and an X2 side of the outer peripheral support member 5 corresponds to a rear side of the outer peripheral support member 5. A Y1 side of the outer peripheral support member 5 corresponds to a left side of the outer peripheral support member 5, and a Y2 side of the outer peripheral support member 5 corresponds to a right side of the outer peripheral support member 5. A Z1 side of the outer peripheral support member 5 corresponds to an upper side of the outer peripheral support member 5, and a Z2 side of the outer peripheral support member 5 corresponds to a lower side of the outer peripheral support member 5. Similar definitions apply to other members in other drawings.

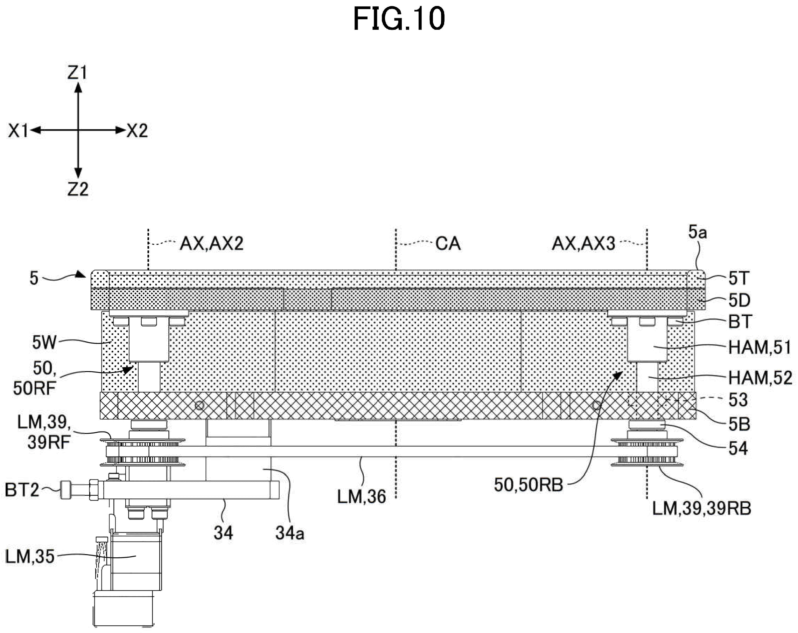

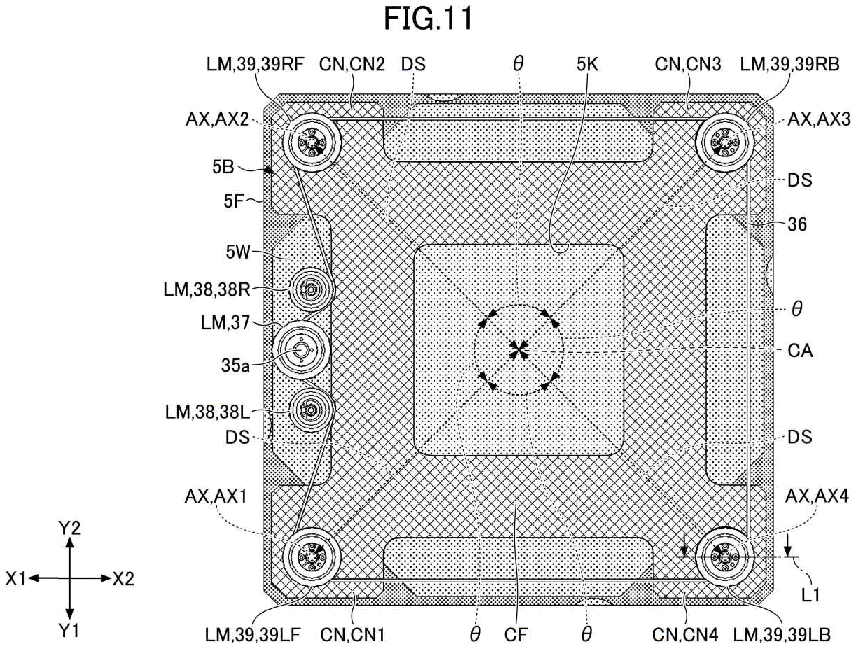

FIG. 10 is a right side view of the outer peripheral support member 5 and the raising and lowering support mechanism 25. In FIG. 10, for clarity, the side cover 5C is not shown, as in the lower part of FIG. 9. FIG. 11 is a bottom view of the outer peripheral support member 5 and the raising and lowering support mechanism 25. In FIG. 11, for clarity, some of the components of the raising and lowering support mechanism 25 (a mounting piece 34 and the rotation motor 35) and the side cover 5C are not shown.

In the illustrated example, the outer peripheral support member 5 includes a base plate 5B, the side cover 5C, a base 5D, a top plate 5T, and an outer peripheral wall 5W, as shown in FIG. 9. Note that, in FIGS. 10 and 11, for clarity, the base plate 5B is indicated by a cross pattern, the base 5D is indicated by a fine dotted pattern, and the top plate 5T and the outer peripheral wall 5W are indicated by a coarse dotted pattern. As shown in the lower part of FIG. 9, the raising and lowering support mechanism 25 includes a raising and lowering mechanism LM configured to raise and lower the outer peripheral support member 5, and a support mechanism 50 configured to support the outer peripheral support member 5.

Specifically, as shown in the lower part of FIG. 9, the raising and lowering mechanism LM includes the mounting piece 34, the rotation motor 35, a transmission belt 36, a drive pulley 37, a tension pulley 38, and a driven pulley 39. The driven pulley 39 includes a left-front driven pulley 39LF, a right-front driven pulley 39RF, a left-rear driven pulley 39LB (not visible in the lower part of FIG. 9), and a right-rear driven pulley 39RB. The tension pulley 38 includes a left tension pulley 38L arranged between the drive pulley 37 and the left-front driven pulley 39LF, and a right tension pulley 38R arranged between the drive pulley 37 and the right-front driven pulley 39RF.

The support mechanism 50 includes a left-front support mechanism 50LF, a right-front support mechanism 50RF, a left-rear support mechanism 50LB (not visible in the lower part of FIG. 9), and a right-rear support mechanism 50RB. In the illustrated example, the left-front support mechanism 50LF, the right-front support mechanism 50RF, the left-rear support mechanism 50LB, and the right-rear support mechanism 50RB have the same structure (the same shape and the same size). Specifically, as shown in FIG. 10, the support mechanism 50 includes a nut 51, a screw 52, a bearing 53, and a spacer 54.

The base plate 5B of the outer peripheral support member 5 is a member configured to support the base 5D, the top plate 5T, and the outer peripheral wall 5W via the support mechanism 50. In the illustrated example, the base plate 5B is fixed to the support 12 (see FIG. 1) of the table raising and lowering mechanism TLM, and is configured to be raised and lowered together with the support 12 by the table raising and lowering mechanism TLM. Specifically, as shown in FIG. 11, the base plate 5B is a metal plate having a substantially rectangular outer shape in plan view, including four corners CN (a first corner CN1 to a fourth corner CN4) and a central portion CF in which a rectangular opening 5K is formed.

The side cover 5C of the outer peripheral support member 5 is a portion that forms a side surface of the outer peripheral support member 5. In the illustrated example, the side cover 5C is mounted on the base plate 5B so as to cover the base plate 5B and the support mechanism 50, as shown in the upper part of FIG. 9.

The base 5D of the outer peripheral support member 5 is a portion that functions as a base for the top plate 5T of the outer peripheral support member 5, and is supported by the support mechanism 50 fixed to the base plate 5B. In the illustrated example, the base 5D is a metal plate having a substantially rectangular annular shape in plan view and having a circular opening for receiving the table 2.

The top plate 5T of the outer peripheral support member 5 is a portion fixed to an upper side of the base 5D. In the illustrated example, similar to the base 5D, the top plate 5T is a metal plate having a substantially rectangular annular shape in plan view and having a circular opening for receiving the table 2.

The outer peripheral wall 5W of the outer peripheral support member 5 is a portion that forms a portion of the exhaust passage 13. In the illustrated example, the outer peripheral wall 5W is a metal member having an open box shape with an octagonal bottom wall and an octagonal tubular sidewall in plan view. The octagonal tubular sidewall is connected to the four pipes 13D (a first pipe 13D1 to a fourth pipe 13D4). Moreover, an upper end of the octagonal tubular sidewall is fixed to the base 5D.

As described above, the outer peripheral support member 5 is configured such that the base 5D, the top plate 5T, and the outer peripheral wall 5W can be raised and lowered with respect to the base plate 5B by the support mechanism 50. Specifically, as shown in FIG. 10, the bearing 53 of the support mechanism 50 is fixed to the base plate 5B. In the illustrated example, the bearing 53 is a ball bearing, and an inner ring thereof is fixed to the screw 52, and an outer ring thereof is fixed to the base plate 5B.

As shown in FIG. 10, the nut 51 of the support mechanism 50 is fixed to the base 5D by a bolt BT. In the illustrated example, the nut 51 is a trapezoidal screw nut, and forms a height adjustment mechanism HAM in cooperation with the trapezoidal screw 52. The height adjustment mechanism HAM is configured such that the nut 51 moves upward (Z1 direction) when the screw 52 is rotated in one direction about a rotation axis AX, and the nut 51 moves downward (Z2 direction) when the screw 52 is rotated in the other direction about the rotation axis AX.

In the illustrated example, as shown in the lower part of FIG. 9, the support mechanism 50 includes: the left-front support mechanism 50LF fixed to the first corner CN1 of the base plate 5B; the right-front support mechanism 50RF fixed to the second corner CN2 of the base plate 5B; the right-rear support mechanism 50RB fixed to the third corner CN3 of the base plate 5B; and the left-rear support mechanism 50LB (not visible in FIG. 9) fixed to the fourth corner CN4 (not visible in the lower part of FIG. 9, refer to FIG. 11) of the base plate 5B.

Specifically, as shown in FIG. 11, the left-front support mechanism 50LF is configured to rotate the screw 52 about a first rotation axis AX1, the right-front support mechanism 50RF is configured to rotate the screw 52 about a second rotation axis AX2, the right-rear support mechanism 50RB is configured to rotate the screw 52 about a third rotation axis AX3, and the left-rear support mechanism 50LB is configured to rotate the screw 52 about a fourth rotation axis AX4.

In the illustrated example, the first rotation axis AX1 to the fourth rotation axis AX4 are located such that distances DS from a central axis CA passing through the center of the table 2 are equal to each other, as shown in FIG. 11. Moreover, the first rotation axis AX1 to the fourth rotation axis AX4 are located such that angles (central angles) between line segments connecting the central axis CA and the first rotation axis AX1 to the fourth rotation axis AX4 are equal to each other, that is, an angle θ (90°).

An operator who adjusts the height of the outer peripheral support member 5 can independently adjust the height of each of the four corners 5N (the first corner 5N1 to the fourth corner 5N4) of the top plate 5T of the outer peripheral support member 5 as shown in the upper part of FIG. 9 by manually rotating the screw 52 of the height adjustment mechanism HAM in each of the left-front support mechanism 50LF, the right-front support mechanism 50RF, the left-rear support mechanism 50LB, and the right-rear support mechanism 50RB, for example.

The raising and lowering mechanism LM is configured to raise and lower the outer peripheral support member 5 by using the height adjustment mechanism HAM included in the support mechanism 50. Specifically, as described above, the raising and lowering mechanism LM includes the mounting piece 34, the rotation motor 35, the transmission belt 36, the drive pulley 37, the tension pulley 38, and the driven pulley 39. The driven pulley 39 includes the left-front driven pulley 39LF, the right-front driven pulley 39RF, the left-rear driven pulley 39LB, and the right-rear driven pulley 39RB. The left-front driven pulley 39LF, the right-front driven pulley 39RF, the left-rear driven pulley 39LB, and the right-rear driven pulley 39RB have the same structure (the same shape and the same size). The tension pulley 38 includes the left tension pulley 38L arranged between the drive pulleys 37 and the left-front driven pulley 39LF, and the right tension pulley 38R arranged between the drive pulley 37 and the right-front driven pulley 39RF. The left tension pulley 38L and the right tension pulley 38R have the same structure (the same shape and the same size).

In the illustrated example, the mounting piece 34 of the raising and lowering mechanism LM is a metal plate on which the rotation motor 35, the drive pulley 37, and the tension pulley 38 are mounted, and is fixed to the base plate 5B of the outer peripheral support member 5 via a bracket 34a (see FIG. 10). The rotation motor 35 is a drive configured to rotate the drive pulley 37, and is mounted on a lower surface of the mounting piece 34. The transmission belt 36 is a belt configured to transmit torque from the drive pulley 37 to the driven pulley 39. The drive pulley 37 is a member configured to rotate the driven pulley 39 via the transmission belt 36. The tension pulley 38 (the left tension pulley 38L and the right tension pulley 38R) is a member configured to adjust the tension of the transmission belt 36. The drive pulley 37, the left tension pulley 38L, and the right tension pulley 38R are mounted on an upper surface of the mounting piece 34. The driven pulley 39 is a member configured to transmit torque to the screw 52 of the support mechanism 50.

In the illustrated example, the driven pulley 39 includes: the left-front driven pulley 39LF fixed to the screw 52 of the left-front support mechanism 50LF: the right-front driven pulley 39RF fixed to the screw 52 of the right-front support mechanism 50RF; the left-rear driven pulley 39LB fixed to the screw 52 of the left-rear support mechanism 50LB; and the right-rear driven pulley 39RB fixed to the screw 52 of the right-rear support mechanism 50RB. Specifically, the left-rear driven pulley 39LB includes a fixed portion and a rotating portion configured to rotate with respect to the fixed portion. The fixed portion is fixed to a lower surface of the base plate 5B of the outer peripheral support member 5 with the spacer 54 interposed therebetween. The rotating portion is fixed to a lower end of the screw 52 so as to rotate integrally with the screw 52. Substantially the same configuration applies to the left-front driven pulley 39LF, the right-front driven pulley 39RF, and the right-rear driven pulley 39RB.

With such a configuration, the raising and lowering mechanism LM can simultaneously rotate the four driven pulleys 39 at the same rotation speed in the same direction by rotating the drive pulley 37 by the rotation motor 35. That is, the raising and lowering mechanism LM can simultaneously rotate the screw 52 of each of the four support mechanisms at the same rotation speed in the same direction. Accordingly, the raising and lowering mechanism LM can raise and lower the four corners 5N (the first corner 5N1 to the fourth corner 5N4) of the top plate 5T of the outer peripheral support member 5 at the same raising and lowering speed.

Note that the height adjustment of the first corner 5N1 using the left-front support mechanism 50LF is typically performed while the screws 52 of the three support mechanisms 50 other than the left-front support mechanism 50LF are not rotated. This is to prevent the heights of other corners 5N from being changed by the height adjustment of the first corner 5N1. Substantially the same configuration applies to the respective height adjustments using the right-front support mechanism 50RF, the left-rear support mechanism 50LB, and the right-rear support mechanism 50RB. Thus, in the illustrated example, the raising and lowering mechanism LM is configured to disengage the transmission belt 36 from the driven pulley 39. Specifically, the raising and lowering mechanism LM is configured to remove the transmission belt 36 from the driven pulley 39 by adjusting the position of the tension pulley 38 with position adjustment bolts BT2 (see the lower part of FIG. 9), that is, by loosening the tension of the transmission belt 36.

With this configuration, for example, when the height adjustment of the first corner 5N1 is performed using the left-front support mechanism 50LF, the operator can disengage the transmission belt 36 from the left-front driven pulley 39LF fixed to the screw 52 of the left-front support mechanism 50LF. Therefore, the operator can rotate only the screw 52 of the left-front support mechanism 50LF without rotating the screws 52 of other support mechanisms 50, and can adjust only the height of the first corner 5N1 without changing the heights of other corners 5N.

However, the driven pulley 39 may be configured to switch between a state where the screw 52 and the driven pulley 39 are integrally rotatable (a state where the screw 52 and the driven pulley 39 are relatively unrotatable) and a state where the screw 52 and the driven pulley 39 are relatively rotatable. In this case, the operator can rotate only the screw 52 of one support mechanism 50 without rotating the screws 52 of other three support mechanisms 50, without disengaging the transmission belt 36 from the driven pulley 39.

With the above-described configuration, the support mechanism 50 including the four height adjustment mechanisms HAM enables, for example, the operator to flexibly adjust the horizontality of the upper surface 5a of the outer peripheral support member 5. Since the rotation axis AX of the height adjustment mechanism HAM (screws 52) also functions as a support axis, the support mechanism 50 also enables the configuration to be simplified, as compared with a configuration in which a support axis is provided separately from the rotation axis of the height adjustment mechanism.

Since the nut 51 and the screw 52 that form the height adjustment mechanism HAM have relatively small diameters (e.g., 12 mm), the nut 51 and the screw 52 may be standard products (commercially available nuts and screws). Therefore, this configuration enables the height adjustment accuracy of the height adjustment mechanism HAM to be enhanced while minimizing an increase in the manufacturing cost of the support mechanism 50.

In the above-described embodiment, a combination of a trapezoidal screw nut and a trapezoidal screw is adopted as the height adjustment mechanism HAM, but a different mechanism such as a ball screw may be adopted.

With the above-described configuration, the raising and lowering mechanism LM enables, for example, the operator to raise and lower the outer peripheral support member 5 by using the support mechanism 50 including the four height adjustment mechanisms HAM.

In the above-described embodiment, the raising and lowering mechanism LM is configured to simultaneously operate the four height adjustment mechanisms HAM by using one rotation motor 35, but may be configured to independently operate the four height adjustment mechanisms HAM by using four rotation motors. In this case, the transmission belt 36, the drive pulley 37, the tension pulley 38, and the driven pulley 39 may be omitted.

In the above-described embodiment, the raising and lowering mechanism LM is configured to raise and lower the outer peripheral support member 5 by operating the height adjustment mechanism HAM using the driven pulley 39. Thus, this configuration enables the operator to easily change the raising and lowering increment of the outer peripheral support member 5. This is because this configuration enables the raising and lowering increment to be changed by changing the number of teeth of the driven pulley 39.

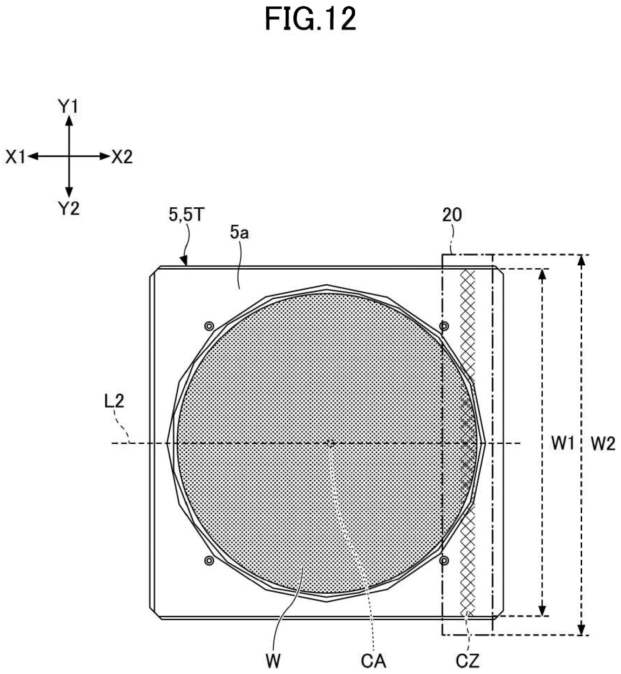

Next, an example of the shape and size of the top plate 5T of the outer peripheral support member 5 in plan view will be described with reference to FIG. 12. FIG. 12 is a top view of the semiconductor wafer W placed on the table 2 and the top plate 5T of the outer peripheral support member 5. Note that, in FIG. 12, for clarity, the upper surface of the semiconductor wafer W is indicated by a dotted pattern. In FIG. 12, the size of the pressing roller 20 in plan view is indicated by a dash-dot line, and a region CZ (contact area) where the pressing roller 20 is in contact with the semiconductor wafer W and the top plate 5T is indicated by a cross pattern. In the illustrated example, the pressing roller 20 is configured to move in the X-axis direction while rolling.

In the illustrated example, the top plate 5T has a substantially rectangular outer shape in plan view, and is configured such that a width W1 in a direction along the rotation axis of the pressing roller 20 (Y-axis direction) is shorter than a width W2 of the pressing roller 20. However, the width W1 of the top plate 5T may be longer than the width W2 of the pressing roller 20, or may be the same as the width W2 of the pressing roller 20.

This configuration enables a total contact area, which is the sum of a contact area (first contact area) between the semiconductor wafer W and the pressing roller 20 and a contact area (second contact area) between the top plate 5T and the pressing roller 20, to be made constant regardless of the position of the pressing roller 20 in the X-axis direction. This means that, if the pressing force applied by the pressing roller 20 is constant, the pressing force per unit contact area in the first contact area can be made constant regardless of the position of the pressing roller 20 in the X-axis direction. Therefore, this configuration enables a film such as the photoresist film 6 to be uniformly attached to the semiconductor wafer W placed on the table 2.

In the illustrated example, the top plate 5T has a shape that is linesymmetric with respect to a broken line L2 parallel to the X-axis passing through the central axis CA. This configuration enables the size of a portion of the first contact area (first left contact area) at one side (Y1 side, left side) of the second contact area and the size of the remaining portion of the first contact area (first right contact area) on the other side (Y2 side, right side) of the second contact area to be made the same regardless of the position of the pressing roller 20 in the X-axis direction. This means that variations in the pressing force applied by the pressing roller 20 in the Y-axis direction can be minimized. Therefore, this configuration enables a film such as the photoresist film 6 to be uniformly attached to the semiconductor wafer W placed on the table 2.

Moreover, since the top plate 5T has a substantially rectangular outer shape in plan view, the film attaching device 1 enables the size of the upper surface 5a of the top plate 5T to be reduced while realizing four-point support by the support mechanism 50, as compared with a case where the top plate has a circular outer shape in plan view. However, the top plate 5T may have an outer shape other than the substantially rectangular shape in plan view (e.g., an outer shape such as a circular shape, a hexagonal shape, or an octagonal shape).

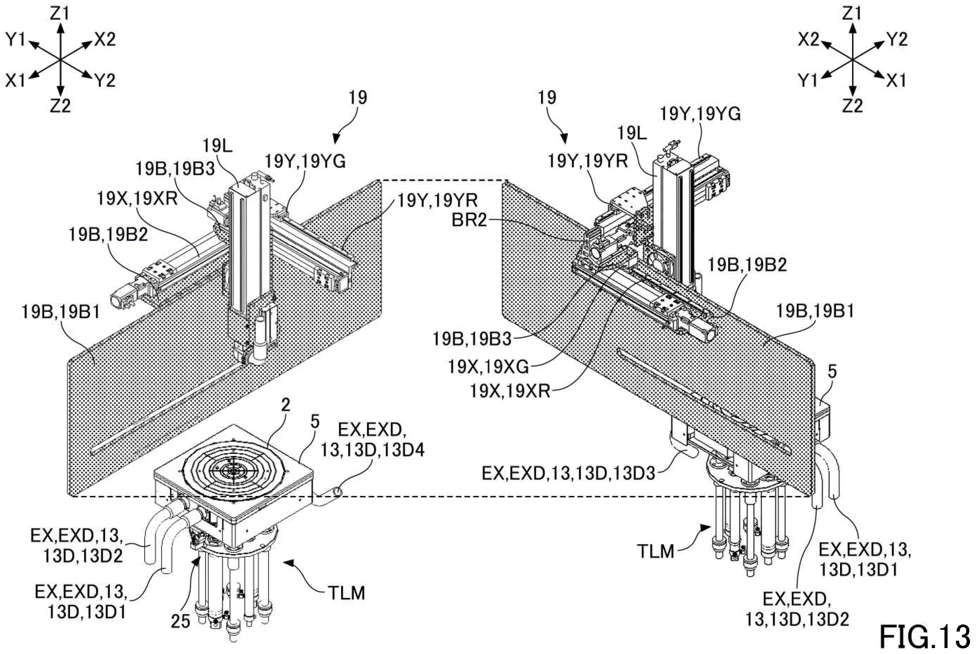

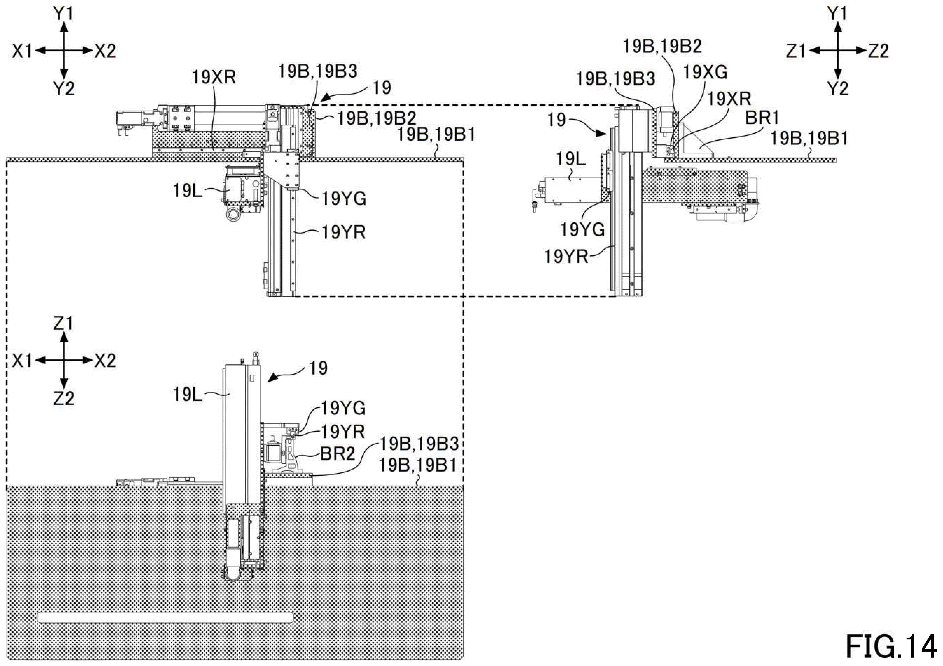

Next, the cutting unit 19 will be described in detail with reference to FIGS. 13 and 14. FIG. 13 is a perspective view showing a configuration example of the cutting unit 19 arranged above the table 2 and the outer peripheral support member 5. Specifically, the left part of FIG. 13 is a perspective view of the table 2, the outer peripheral support member 5, the cutting unit 19, the raising and lowering support mechanism 25, and the table raising and lowering mechanism TLM as viewed obliquely from the upper right, and the right part of FIG. 13 is a perspective view of the table 2, the outer peripheral support member 5, the cutting unit 19, the raising and lowering support mechanism 25, and the table raising and lowering mechanism TLM as viewed obliquely from the upper left. FIG. 14 is a three view drawing (a top view, a rear view, and a right side view) of the cutting unit 19 in FIG. 13. Note that, in FIGS. 13 and 14, for clarity, flat plate members (e.g., a support plate 19B) configured to support other members are indicated by a dotted pattern.

Specifically, the cutting unit 19 includes the support plate 19B, a first linear motion device 19X, a second linear motion device 19Y, and a laser unit 19L.

The support plate 19B is a member configured to support each member included in the cutting unit 19. In the illustrated example, the support plate 19B is a flat plate member formed of a metal, and includes a first support plate 19B1, a second support plate 19B2, and a third support plate 19B3. The first support plate 19B1 is a member configured to support the entire cutting unit 19, and is arranged so as to extend parallel to the XZ plane. The second support plate 19B2 is a member on which the first linear motion device 19X is mounted, extends parallel to the XY plane, and is mounted on a left surface (a side surface in Y1) of the first support plate 19B1 via a first bracket BR1 as shown in the rear view of FIG. 14. The third support plate 19B3 is a member on which the second linear motion device 19Y is mounted, extends parallel to the XY plane, and is mounted on a first guide block 19XG, which is a movable portion of the first linear motion device 19X as shown in the rear view of FIG. 14.

The first linear motion device 19X is a device configured to move the movable portion along the X-axis direction. In the illustrated example, the first linear motion device 19X is an electric linear actuator, and includes the first guide block 19XG serving as the movable portion and a first guide rail 19XR serving as a fixed portion. The second linear motion device 19Y is a device configured to move a movable portion along the Y-axis direction. In the illustrated example, the second linear motion device 19Y is an electric linear actuator, and includes a second guide block 19YG serving as the movable portion and a second guide rail 19YR serving as a fixed portion. As shown in the right side view of FIG. 14, the second guide rail 19YR is fixed to the third support plate 19B3 via a second bracket BR2. The first linear motion device 19X and the second linear motion device 19Y are configured to operate in response to a command from the controller 40.

The laser unit 19L is a device configured to emit a laser toward the film. In the illustrated example, the laser unit 19L is configured to be movable in parallel in the X-axis direction by the first linear motion device 19X and movable in parallel in the Y-axis direction by the second linear motion device 19Y. That is, the laser unit 19L is configured to be movable in parallel along the XY plane above the table 2 and the outer peripheral support member 5.

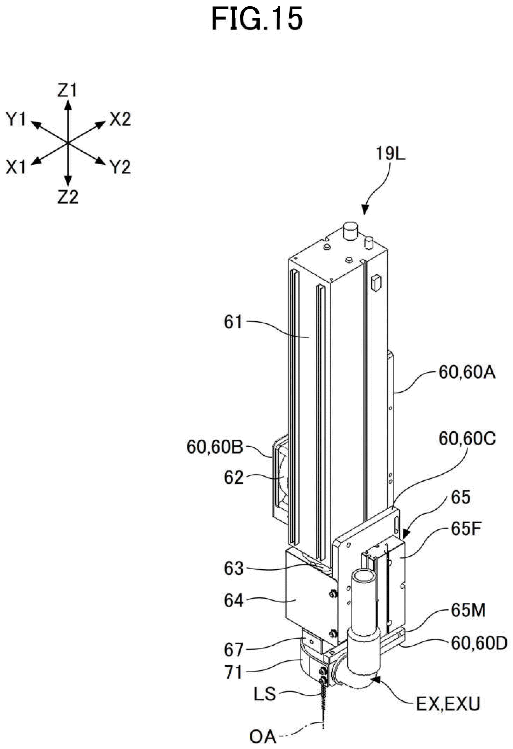

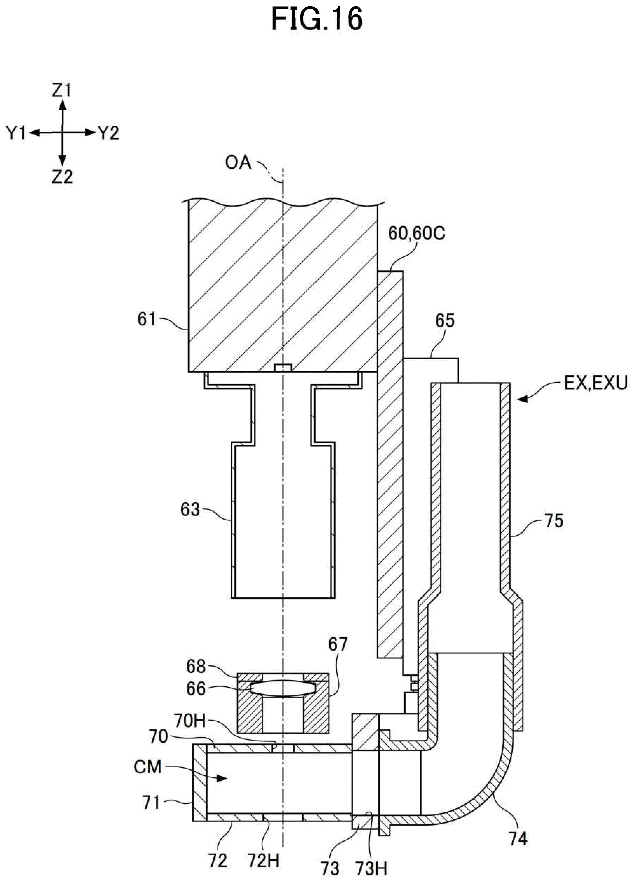

Herein, the laser unit 19L will be described in detail with reference to FIGS. 15 and 16. FIG. 15 is a view showing a configuration example of the laser unit 19L. FIG. 16 is a view of a cross section of the laser unit 19L taken along an imaginary plane parallel to the YZ plane including an optical axis OA in FIG. 15, as viewed from the X1 direction.

As shown in FIGS. 15 and 16, the laser unit 19L includes a support plate 60, a laser source 61, a cooling fan 62, a beam expander 63, a cover 64, a linear motion device 65, a condenser lens 66, a lens holder 67, a lens cover 68, and an upper discharge system EXU.

The support plate 60 is a member configured to support each member included in the laser unit 19L. In the illustrated example, the support plate 60 is a flat plate member formed of a metal, and includes a first support plate 60A, a second support plate 60B, a third support plate 60C, and a fourth support plate 60D. The first support plate 60A is a member configured to support the laser source 61, and is arranged so as to extend parallel to the YZ plane. The second support plate 60B is a member on which the cooling fan 62 is mounted, extends parallel to the XZ plane, and is mounted on the first support plate 60A so as to be perpendicular to the first support plate 60A. The third support plate 60C is a member on which the linear motion device 65 is mounted, extends parallel to the XZ plane so as to be opposite to the cooling fan 62 mounted on the second support plate 60B, with the laser source 61 interposed between the third support plate 60C and the cooling fan, and is mounted on the first support plate 60A so as to be perpendicular to the first support plate 60A. The fourth support plate 60D is a member on which the upper discharge system EXU is mounted, is fixed to a movable portion 65M of the linear motion device 65 with a fastener such as a bolt, and is arranged so as to extend parallel to the XY plane.

The laser source 61 is a device configured to emit a laser LS. In the illustrated example, the laser source 61 is configured to emit the laser LS (carbon dioxide laser) downward along the optical axis OA extending in the Z-axis direction. The laser source 61 is configured to operate in response to a command from the controller 40. Note that the laser LS may be a laser other than a carbon dioxide laser, such as a fiber laser, a YAG laser, or an ultraviolet laser. The laser source 61 may be configured to change the direction of the laser LS. That is, the laser source 61 may be configured to scan the laser LS over the photoresist film 6. The laser source 61 may also be configured to adjust the intensity of the laser LS in response to a command from the controller 40.

The cooling fan 62 is a device configured to cool the laser source 61. In the illustrated example, the cooling fan 62 is an electric fan and is configured to operate in response to a command from the controller 40.

The beam expander 63 is an optical device configured to expand or reduce the beam diameter of the laser LS emitted from the laser source 61. In the illustrated example, the beam expander 63 is configured to expand the beam diameter of the laser LS emitted from the laser source 61 and to cause the laser LS having the expanded beam diameter to be incident on the condenser lens 66.

The cover 64 is a member configured to cover the beam expander 63. In the illustrated example, the cover 64 is an L-shaped metal plate and is fastened to the third support plate 60C with a fastener such as a bolt.

The linear motion device 65 is a device configured to move a movable portion along the Z-axis direction. In the illustrated example, the linear motion device 65 is an electric linear actuator and is configured to operate in response to a command from the controller 40. Specifically, the linear motion device 65 includes a fixed portion 65F and a movable portion 65M, and is configured to move the movable portion 65F vertically with respect to the fixed portion 65M.

The condenser lens 66 is an optical element configured to condense the laser LS. In the illustrated example, the condenser lens 66 is configured to condense the laser LS, which is emitted from the laser source 61 and expanded in beam diameter by the beam expander 63, to form a laser spot on the upper surface of the photoresist film 6.

The lens holder 67 is a member configured to retain the condenser lens 66 in cooperation with the lens cover 68. In the illustrated example, the lens holder 67 is fixed to a top plate member 70 of the upper discharge system EXU with an adhesive. However, the lens holder 67 may be fixed to the upper discharge system EXU by a different method, such as fastening with a fastener.

The lens cover 68 is a member configured to retain the condenser lens 66 in cooperation with the lens holder 67. In the illustrated example, the lens cover 68 has an opening for allowing the passage of the laser LS, and is fixed to the upper side of the lens holder 67 with a fastener (not shown).

The upper discharge system EXU is a part of the discharge system EX configured to remove foreign matter and unwanted matter generated when the film is cut by the cutting unit 19. In the illustrated example, the upper discharge system EXU is fixed to the fourth support plate 60D with a fastener (not shown). Thus, the controller 40 can move the upper discharge system EXU vertically by driving the linear motion device 65. Since the lens holder 67 is fixed to the upper discharge system EXU, the controller 40 can also move, along the optical axis OA, the condenser lens 66 retained by the lens holder 67. Thus, the controller 40 can drive the linear motion device 65 to adjust the distance between the photoresist film 6 and the condenser lens 66, and can set the distance to the focal length of the condenser lens 66.

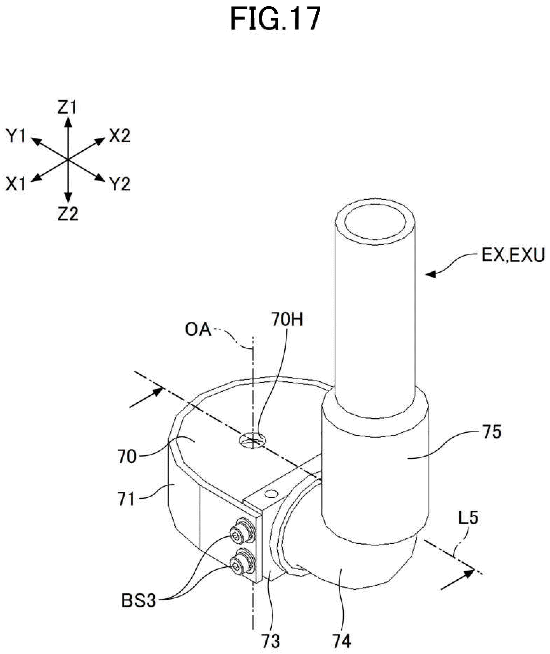

Herein, the upper discharge system EXU will be described in detail with reference to FIG. 17. FIG. 17 is a perspective view showing a configuration example of the upper discharge system EXU.

As shown in FIG. 17, the upper discharge system EXU includes the top plate member 70, a first side plate member 71, a bottom plate member 72 (see FIG. 16), a second side plate member 73, a bent pipe 74, and a straight pipe 75.

The top plate member 70 is a member that forms the ceiling of a compartment CM (see FIG. 16). The compartment CM is a room configured to confine unwanted matter generated when the film is cut by the cutting unit 19 so as to prevent the unwanted matter from diffusing outside the compartment CM. In the illustrated example, the top plate member 70 is formed of a metal plate and has a shape formed by combining a semicircle and a rectangle in plan view.

The first side plate member 71 is a member that forms a part of a sidewall of the compartment CM. In the illustrated example, the first side plate member 71 is formed of a metal plate, and is bent and arranged so as to surround a curved portion of the semicircle and a short side of the rectangle of the top plate member 70.

The bottom plate member 72 (see FIG. 16) is a member that forms an inner bottom surface of the compartment CM. In the illustrated example, the bottom plate member 72 is formed of a metal plate and is formed to have the same shape and the same size as the top plate member 70 in plan view.

The second side plate member 73 is a member that partitions the remaining portion of the sidewall of the compartment CM. In the illustrated example, the second side plate member 73 is formed of a metal plate and is arranged so as to be in contact with one of long sides of the rectangle of the top plate member 70.

A through-hole 70H for passing the laser LS is formed in the top plate member 70. Similarly, a through-hole 72H (see FIG. 16) for passing the laser LS is formed in the bottom plate member 72. A through-hole 73H (see FIG. 16) for discharging the unwanted matter is formed in the second side plate member 73. In the illustrated example, the diameter of the through-hole 70H is smaller than the diameter of the through-hole 72H and is smaller than the diameter of the through-hole 73H. This is to minimize the unwanted matter escaping through the through-hole 70H.

The bent pipe 74 is a part of an exhaust passage for discharging the unwanted matter. In the illustrated example, one end of the bent pipe 74 is coupled to the second side plate member 73, and the other end is coupled to one end of the straight pipe 75. Specifically, the bent pipe 74 is a 90-degree bent pipe arranged such that an opening at one end (inlet) is directed leftward (Y1 direction) and an opening at the other end (outlet) is directed upward (Z1 direction). Note that the bent pipe 74 may be a bent pipe having a bending angle other than 90 degrees, such as an 80-degree bent pipe or a 100-degree bent pipe.

The straight pipe 75 is another part of the exhaust passage for discharging the unwanted matter. In the illustrated example, one end of the straight pipe 75 is coupled to the bent pipe 74, and the other end is connected to one end of a flexible tube (now shown). Note that the other end of the tube is directly or indirectly connected to an exhaust device such as an exhaust fan. The straight pipe 75 may be replaced with a bent pipe or may be omitted.

In the illustrated example, the upper discharge system EXU forms a part of the laser unit 19L, is configured to move in each of the X-axis direction and the Y-axis direction together with the laser source 61, and is configured to move in the Z-axis direction with respect to the laser source 61 by the linear motion device 65. However, the upper discharge system EXU may be provided separately from the laser unit 19L. That is, the upper discharge system EXU may be provided independently of the other members (the support plate 60, the laser source 61, the cooling fan 62, the beam expander 63, the cover 64, the linear motion device 65, the condenser lens 66, the lens holder 67, and the lens cover 68) forming the laser unit 19L, and may be configured to move in each of the X-axis direction, the Y-axis direction, and the Z-axis direction. In this case, the upper discharge system EXU may be configured to move in the X-axis direction and the Y-axis direction. That is, the upper discharge system EXU may be configured not to move in the Z-axis direction.

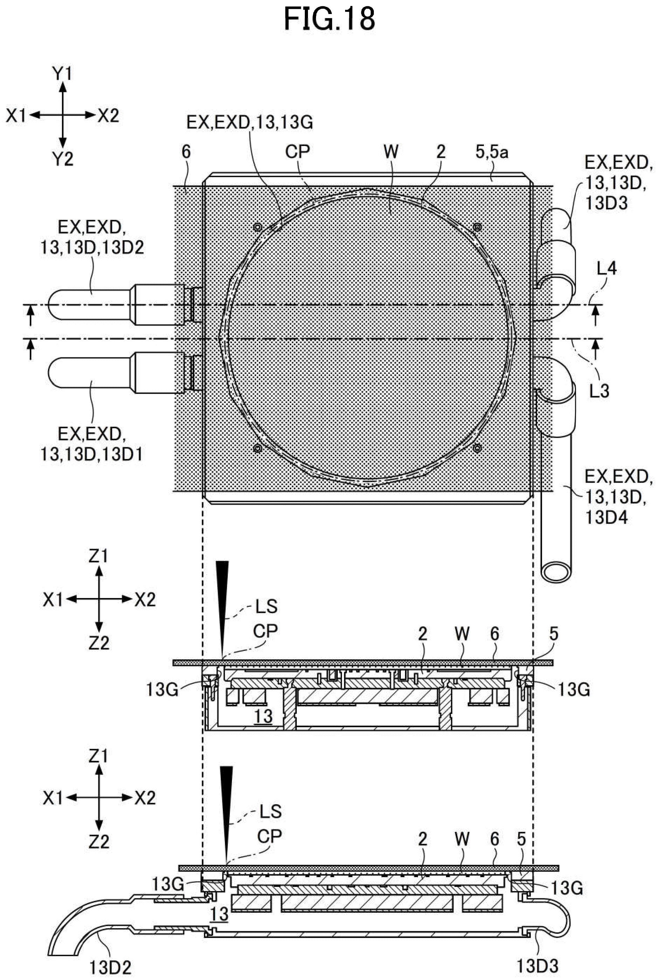

Next, the lower discharge system EXD will be described in detail with reference to FIG. 18. FIG. 18 is views showing a configuration example of the lower discharge system EXD. Specifically, the upper part of FIG. 18 is a top view of the photoresist film 6 attached to the semiconductor wafer W placed on the upper surface of the table 2 and the upper surface 5a of the outer peripheral support member 5. Note that, in the upper part of FIG. 18, for clarity, the photoresist film 6 is indicated by a dotted pattern. The middle and lower parts of FIG. 18 are cross-sectional views of the table 2, the outer peripheral support member 5, the photoresist film 6, and the semiconductor wafer W. Specifically, the middle part of FIG. 18 is a view of cross sections of the table 2, the outer peripheral support member 5, the photoresist film 6, and the semiconductor wafer W taken along an imaginary plane parallel to the XZ plane including a dash-dot line L3 in the upper part of FIG. 18, as viewed from the Y2 direction. The lower part of FIG. 18 is a view of cross sections of the table 2, the outer peripheral support member 5, the photoresist film 6, and the semiconductor wafer W taken along an imaginary plane parallel to the XZ plane including a dash-dot line L4 in the upper part of FIG. 18, as viewed from the Y2 direction. Note that FIG. 18 shows the photoresist film 6 before being cut by the cutting unit 19.

Specifically, the lower discharge system EXD includes the exhaust passage 13 and the exhaust device 14. Before the photoresist film 6 is cut by the cutting unit 19, the exhaust device 14 discharges air from the exhaust passage 13 (the pipes 13D and the gap 13G) located below a cutting target portion CP of the photoresist film 6, thereby bringing the exhaust passage 13 into a negative-pressure state. This is because the inlet (the upper part of the gap 13G) is blocked by the photoresist film 6. The cutting target portion CP of the photoresist film 6 is a portion to be cut by the cutting unit 19, that is, a portion where the spot of the laser LS emitted from the laser unit 19L is positioned.

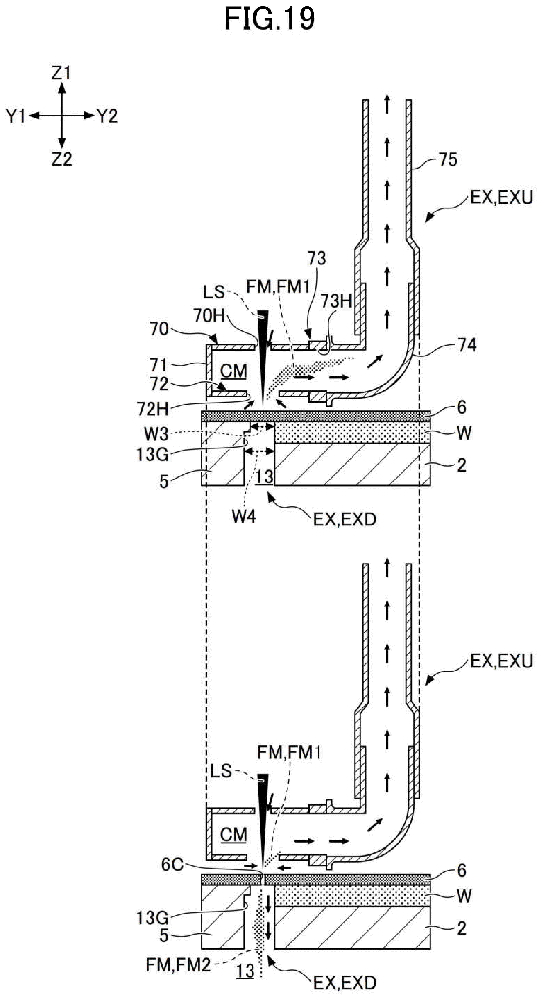

Next, the flow of smoke FM discharged to the outside of the film attaching device 1 by the discharge system EX will be described with reference to FIG. 19. FIG. 19 is a cross-sectional view of the photoresist film 6, the semiconductor wafer W, and the discharge system EX. Specifically, the upper part of FIG. 19 is a cross-sectional view immediately after the photoresist film 6 is irradiated with the laser LS, that is, before the photoresist film 6 is cut, and includes a cross section of the upper discharge system EXU taken along an imaginary plane parallel to the YZ plane including a dash-dot line L5 in FIG. 17. The lower part of FIG. 19 is a cross-sectional view after a part of the cutting target portion CP of the photoresist film 6 is cut to form a through portion 6C, and corresponds to the upper part of FIG. 19. The through portion 6C is a portion that connects a space above the photoresist film 6 and a space below the photoresist film 6, and is formed by cutting the photoresist film 6 with the laser LS. Note that, in FIG. 19, the flow of air in the discharge system EX is indicated by black arrows.

The smoke FM is part of the unwanted matter generated when the photoresist film 6 is heated by the laser LS emitted from the laser unit 19L. In the illustrated example, the smoke FM includes upper smoke FM1 discharged to the outside by the upper discharge system EXU and lower smoke FM2 discharged to the outside by the lower discharge system EXD.

Before the through portion 6C is formed, the smoke FM does not include the lower smoke FM2 as shown in the upper part of FIG. 19. This is because there is no flow of air flowing into the exhaust passage 13 from the space above the photoresist film 6. Therefore, most of the smoke FM (the upper smoke FM1) is discharged to the outside by the upper discharge system EXU.

After the through portion 6C is formed, the smoke FM includes the lower smoke FM2 as shown in the lower part of FIG. 19. This is because there is the flow of air flowing into the exhaust passage 13 from the space above the photoresist film 6. Therefore, part of the smoke FM (the upper smoke FM1) is discharged to the outside by the upper discharge system EXU, and another part of the smoke FM (the lower smoke FM2) is discharged to the outside by the lower discharge system EXD.

In the illustrated example, the discharge system EX is configured such that the flow rate of air discharged to the outside by the lower discharge system EXD is greater than the flow rate of air discharged to the outside by the upper discharge system EXU. Thus, the amount of lower smoke FM2 discharged to the outside by the lower discharge system EXD is greater than the amount of upper smoke FM1 discharged to the outside by the upper discharge system EXU.

As described above, as shown in FIG. 1, the semiconductor manufacturing device (the film attaching device 1) according to an embodiment of the present disclosure includes: the table 2 configured to support the semiconductor wafer W; the pressing member (the pressing roller 20) configured to press a film (the photoresist film 6) to be attached to the semiconductor wafer W placed on the table 2; the outer peripheral support member 5 provided on an outer peripheral side of the table 2 and arranged so as to receive a pressing force from the pressing member (the pressing roller 20) when the pressing member (the pressing roller 20) presses the film (the photoresist film 6); and the support mechanism 50 configured to support the outer peripheral support member 5 at at least three positions spaced apart from each other in plan view and independently adjust a height of the outer peripheral support member 5 at the at least three positions. In the example shown in FIG. 1, the support mechanism 50 includes the left-front support mechanism 50LF, the right-front support mechanism 50RF, the left-rear support mechanism 50LB, and the right-rear support mechanism 50RB. Each of the left-front support mechanism 50LF, the right-front support mechanism 50RF, the left-rear support mechanism 50LB, and the right-rear support mechanism 50RB has the height adjustment mechanism HAM. In the illustrated example, the semiconductor manufacturing device is the film attaching device 1, which is an example of a laminator, but may be a mounter that attaches a film to a ring. That is, the outer peripheral support member 5 supported by the support mechanism 50 may be mounted on a mounter as a member on which the ring is placed. The same applies to features described below. That is, the features described below may be mounted on the mounter. The film may be a resin film, a polyimide film, or the like having heat-sensitive adhesiveness or photosensitivity.

With this configuration, the semiconductor manufacturing device is capable of correcting the inclination of the upper surface of the outer peripheral support member 5. Specifically, the semiconductor manufacturing device enables the operator to adjust the horizontality of the upper surface 5a of the outer peripheral support member 5.

The semiconductor manufacturing device (the film attaching device 1) may include the raising and lowering mechanism LM configured to raise and lower the outer peripheral support member 5. In the illustrated example, the raising and lowering mechanism LM includes the rotation motor 35, the transmission belt 36, the drive pulley 37, the tension pulley 38, and the driven pulley 39, as shown in FIGS. 10 and 11. However, the raising and lowering mechanism LM may include other mechanical elements such as a gear, a chain, or a wire. The raising and lowering mechanism LM may be omitted. Even in this case, the operator can adjust the horizontality of the upper surface 5a of the outer peripheral support member 5 by using the height adjustment mechanism HAM in each of the left-front support mechanism 50LF, the right-front support mechanism 50RF, the left-rear support mechanism 50LB, and the right-rear support mechanism 50RB. The operator can also make the semiconductor wafer W placed on the upper surface of the table 2 and the upper surface 5a of the outer peripheral support member 5 flush with each other by raising and lowering the table 2.

As shown in FIG. 9, the outer peripheral support member 5 may have a substantially rectangular outer shape in plan view and may be arranged so as to surround the table 2. In this case, the height adjustment mechanism HAM may be configured to independently adjust the height of each of the four corners of the outer peripheral support member 5.

With this configuration, the semiconductor manufacturing device is capable of correcting the inclination of the upper surface of the outer peripheral support member 5 even when the outer peripheral support member 5 is supported at four points by the support mechanism 50, for example.

The raising and lowering mechanism LM may be configured to simultaneously raise and lower the four corners of the outer peripheral support member 5. In the illustrated example, the raising and lowering mechanism LM is configured to raise and lower the outer peripheral support member 5 by simultaneously operating the height adjustment mechanism HAM in each of the left-front support mechanism 50LF, the right-front support mechanism 50RF, the left-rear support mechanism 50LB, and the right-rear support mechanism 50RB.

With this configuration, the semiconductor manufacturing device is capable of raising and lowering the outer peripheral support member 5 with the inclination of the upper surface of the outer peripheral support member 5 corrected. Specifically, the semiconductor manufacturing device enables the operator to raise and lower the outer peripheral support member 5 while the horizontality of the upper surface 5a of the outer peripheral support member 5 is maintained.

As shown in FIG. 1, the film attaching device 1, which is an example of the semiconductor manufacturing device according to an embodiment of the present disclosure, includes: the table 2 configured to support the semiconductor wafer W; and the cutting unit 19 configured to cut, with a laser, a film (the photoresist film 6) to be attached to the semiconductor wafer W placed on the table 2. As shown in FIG. 15, the cutting unit 19 may include the laser source 61 and the beam expander 63 configured to expand or reduce the beam diameter of the laser LS emitted from the laser source 61. Note that the laser LS may be, for example, a carbon dioxide laser, a fiber laser, a YAG laser, or an ultraviolet laser. The beam expander 63 may be a Galilean beam expander or a Keplerian beam expander. The beam expander 63 may be a fixed-magnification beam expander or a variablemagnification zoom expander.

With this configuration, the film attaching device 1 can reduce the size of the spot (spot diameter) of the laser LS formed on the upper surface of the film when the film is cut. Therefore, this configuration enables the quality of the cut edge of the film to be enhanced. Note that enhancing the quality of the cut edge of the film includes minimizing degradation of the quality of the cut edge of the film, such as reducing the occurrence of burrs. This configuration also enables the film to be cut with a lower laser power than when the spot diameter is large.

As shown in FIGS. 1 and 15, the film attaching device 1 may include the discharge system EX configured to generate suction and discharge, to the outside, the unwanted matter generated when the film (the photoresist film 6) is cut by the cutting unit 19. In this case, the cutting unit 19 may be configured to move in parallel to the upper surface of the table 2 as shown in FIG. 13. That is, the cutting unit 19 may be configured to move in parallel in each of the X-axis direction and the Y-axis direction. As shown in FIG. 15, the laser source 61 may be configured to emit the laser LS having the optical axis OA perpendicular to the upper surface of the table 2. The discharge system EX may include the upper discharge system EXU provided above the film (photoresist film 6). The upper discharge system EXU may be configured to move integrally with the cutting unit 19.

With this configuration, the film attaching device 1 can make the positional relationship among the film, the laser LS, and the upper discharge system EXU the same when the film is cut as the cutting unit 19 is moved. Therefore, as compared with, for example, a configuration in which the positional relationship among the film, the laser LS, and the discharge system changes during cutting of the film, this configuration enables stable removal of the smoke FM generated when the film is cut, thereby suppressing scattering of the laser LS caused by the smoke FM and, in turn, suppressing degradation of the quality of the cut edge of the film.

As shown in FIG. 18, the cutting unit 19 may be configured to cut the cutting target portion CP of the film (the photoresist film 6) attached to the semiconductor wafer W, the cutting target portion CP being a portion along the outer edge of the semiconductor wafer W. In this case, the discharge system EX may include the lower discharge system EXD provided below the film (the photoresist film 6). The lower discharge system EXD may include the exhaust device 14 (see FIG. 1) connected to the exhaust passage 13 (the pipes 13D and the gap 13G) located below the cutting target portion CP of the film (the photoresist film 6).

In particular, the annular gap 13G may be formed between the table 2 and the outer peripheral support member 5. The gap 13G may form the exhaust passage 13 of the lower discharge system EXD.

With this configuration, the film attaching device 1 can form a flow of air from the space above the film toward the space below the film after the through portion 6C is formed in the film. Therefore, this configuration can cool the cut edge of the film, which is heated by the laser LS, by blowing air to the cut edge, and thus enables the quality of the cut edge of the film to be enhanced. This configuration can draw the smoke FM generated when the film is cut into the space below the film and, compared with a configuration not including the lower discharge system, can suppress scattering of the laser LS caused by the smoke FM and, in turn, suppress degradation of the quality of the cut edge of the film.

As shown in the upper part of FIG. 19, the width of the gap 13G may be configured to increase stepwise in a direction away from the film (downward). Specifically, the gap 13G may be configured such that a width W3 of a portion closer to the film is shorter than a width W4 of a portion farther from the film.

With this configuration, the lower discharge system EXD can make the flow rate of air flowing through a portion close to the film greater than the flow rate of air flowing through a portion far from the film in the gap 13G. Therefore, this configuration can cool the cut edge of the film more efficiently than a configuration in which the width of the gap 13G does not change in the vertical direction or a configuration in which the width of the gap 13G decreases in a direction away from the film (downward), thereby further improving the quality of the cut edge of the film. Note that, in the illustrated example, the gap 13G is configured to increase stepwise in a direction away from the film, but may be configured to increase in a reverse tapered manner in a direction away from the film.

The discharge system EX may be configured such that the flow rate of gas discharged to the outside by the lower discharge system EXD is greater than the flow rate of gas discharged to the outside by the upper discharge system EXU.

With this configuration, as shown in the lower part of FIG. 19, the film attaching device 1 can make the amount of lower smoke FM2 discharged to the outside by the lower discharge system EXD greater than the amount of upper smoke FM1 discharged to the outside by the upper discharge system EXU. Therefore, this configuration can reduce the amount of upper smoke FM1 in the space above the film and suppress scattering of the laser LS caused by the upper smoke FM1, and thus can suppress degradation of the quality of the cut edge of the film. This configuration also can suppress the cut edge of the film from being directed upward and suppress the cut edge directed upward from interfering with the subsequent cutting of the cutting target portion CP by the laser LS. This is because the cut edge of the film is drawn downward by the air flowing downward. Therefore, this configuration enables the quality of the cut edge of the film to be further enhanced.

The preferred embodiments of the present invention have been described in detail above. However, the present invention is not limited to the above-described embodiments. Various modifications, substitutions, and the like can be applied to the above-described embodiment without departing from the scope of the present invention. The features described with reference to the above-described embodiments may be combined as appropriate without technical inconsistency.

This application claims priority based on Japanese Patent Application No. 2023-141613 filed on August 31, 2023, the entire contents of which are incorporated herein by reference.

**Reference Sign List**

| | | | |
|---|---|---|---|
| 1 | Film attaching device | 2 | Table |
| 2G | Groove | 3 | Film supply unit |
| 4 | Winding unit | 5 | Outer peripheral support member |
| 5a | Upper surface | 5B | Base plate |
| 5C | Side cover | 5D | Base |
| 5K | Opening | 5N | Corner |
| 5N1 | First corner | 5N2 | Second corner |
| 5N3 | Third corner | 5N4 | Fourth corner |
| 5P | Coupling plate | 5T | Top plate |
| 5W | Outer peripheral wall | 6 | Photoresist film |
| 6C | Through portion | 7 | Carrier film |
| 8 | Reinforcing film | 9 | Pinch roller |
| 10 | Slide rod | 11 | Base plate |
| 12 | Support | 13 | Exhaust passage |
| 13D | Pipe | 13D1 | First pipe |
| 13D2 | Second pipe | 13D3 | Third pipe |
| 13D4 | Fourth pipe | 13G | Gap |
| 14 | Exhaust device | 15 | Slide shaft |
| 16 | First moving unit | 17 | Second moving unit |
| 18 | Third moving unit | 19 | Cutting unit |
| 19B | Support plate | 19B1 | First support plate |
| 19B2 | Second support plate | 19B3 | Third support plate |
| 19L | Laser unit | 19X | First linear motion device |
| 19XG | First guide block | 19XR | First guide rail |
| 19Y | Second linear motion device | 19YG | Second guide block |
| 19YR | Second guide rail | 20 | Pressing roller |
| 21 | Pressing-force adjustment mechanism | | |
| 22 | Pressing cylinder | 22a | Piston rod |
| 25 | Raising and lowering support mechanism | | |
| 34 | Mounting piece | 34a | Bracket |
| 35 | Rotation motor | 36 | Transmission belt |
| 37 | Drive pulley | 38 | Tension pulley |
| 38L | Left tension pulley | 38R | Right tension pulley |
| 39 | Driven pulley | 39LB | Left-rear driven pulley |
| 39LF | Left-front driven pulley | 39RB | Right-rear driven pulley |
| 39RF | Right-front driven pulley | 40 | Controller |
| 41 | Input device | 42 | Height level storage |
| 43 | Pressing pattern storage | 50 | Support mechanism |
| 50LB | Left-rear support mechanism | 50LF | Left-front support mechanism |
| 50RB | Right-rear support mechanism | 50RF | Right-front support mechanism |
| 51 | Nut | 52 | Screw |
| 53 | Bearing | 54 | Spacer |
| 60 | Support plate | 60A | First support plate |
| 60B | Second support plate | 60C | Third support plate |
| 60D | Fourth support plate | 61 | Laser source |
| 62 | Cooling fan | 63 | Beam expander |
| 64 | Cover | 65 | Linear motion device |
| 65F | Fixed portion | 65M | Movable portion |
| 66 | Condenser lens | 67 | Lens holder |
| 68 | Lens cover | 70 | Top plate member |
| 70H | Through-hole | 71 | First side plate member |
| 72 | Bottom plate member | 72H | Through-hole |
| 73 | Second side plate member | 73H | Through-hole |
| 74 | Bent pipe | 75 | Straight pipe |
| 80 | Hollow structure | 81 | Wall |
| 82 | Top portion | AX | Rotation axis |
| AX1 | First rotation axis | AX2 | Second rotation axis |
| AX3 | Third rotation axis | AX4 | Fourth rotation axis |
| BR1 | First bracket | BR2 | Second bracket |
| BT | Bolt | BT2 | Position adjustment bolt |
| CA | Central axis | CF | Central portion |
| CM | Compartment | CN | Corner |
| CN1 | First corner | CN2 | Second corner |
| CN3 | Third corner | CN4 | Fourth corner |
| CP | Cutting target portion | CZ | Region |
| F2 | Two-layer film | EX | Discharge system |
| EXD | Lower discharge system | EXU | Upper discharge system |
| F3 | Three-layer film | FM | Smoke |
| FM1 | Upper smoke | FM2 | Lower smoke |
| HAM | Height adjustment mechanism | LM | Raising and lowering mechanism |
| LS | Laser | OA | Optical axis |
| TLM | Table raising and lowering mechanism | | |
| W | Semiconductor wafer | | |

## Claims

1. A semiconductor manufacturing device, comprising:
a table configured to support a semiconductor wafer; and
a film-cutting mechanism configured to cut a film with a laser, the film being attached to the semiconductor wafer placed on the table, wherein
the film-cutting mechanism includes:
a laser source; and
a beam expander configured to expand or reduce a beam diameter of the laser emitted from the laser source.

2. The semiconductor manufacturing device according to claim 1, further comprising:
a discharge system configured to generate suction and discharge, to an outside, unwanted matter generated when the film is cut by the film-cutting mechanism, wherein
the film-cutting mechanism is configured to move in parallel to an upper surface of the table,
the discharge system includes an upper discharge system provided above the film, and
the upper discharge system is configured to move integrally with the film-cutting mechanism.

3. The semiconductor manufacturing device according to claim 2, wherein
the film-cutting mechanism is configured to cut a cutting target portion of the film attached to the semiconductor wafer, the cutting target portion being a portion along an outer edge of the semiconductor wafer,
the discharge system includes a lower discharge system provided below the film, and
the lower discharge system includes an exhaust device connected to an exhaust passage located below the cutting target portion of the film.

4. The semiconductor manufacturing device according to claim 3, further comprising:
a pressing member configured to press the film to be attached to the semiconductor wafer placed on the table; and
an outer peripheral support member provided on an outer peripheral side of the table and arranged so as to receive a pressing force from the pressing member when the pressing member presses the film, wherein
an annular gap is formed between the table and the outer peripheral support member, and
the annular gap forms the exhaust passage of the lower discharge system.

5. The semiconductor manufacturing device according to claim 3, wherein
a flow rate of gas discharged to the outside by the lower discharge system is greater than a flow rate of gas discharged to the outside by the upper discharge system.

6. A film-cutting mechanism configured to cut, with a laser, a film attached to a semiconductor wafer placed on a table, the film-cutting mechanism comprising:
a laser source; and
a beam expander configured to expand or reduce a beam diameter of the laser emitted from the laser source.
